# EUROPEAN PATENT APPLICATION

(11) **EP 4 401 299 A1**
(43) Date of publication of application: **17.07.2024**
(21) Application number: 22867430.5
(22) Date of filing: 09.09.2022
(51) Int. Cl.: H02N 11/00, H01M 10/46, H10N 15/00

(54) **POWER GENERATION FUNCTION-EQUIPPED SECONDARY BATTERY**

(30) Priority: 10.09.2021 JP 2021147809; 06.01.2022 JP 2022001329
(71) Applicant: GCE Institute Inc., Tokyo 104-0061 (JP)
(72) Inventor: GOTO, Hiroshi, Tokyo 104-0061 (JP); SAKATA, Minoru, Tokyo 104-0061 (JP); YASUDA, Takuo, Tokyo 104-0061 (JP); ANDERSSON, Lars Mattias, Tokyo 104-0061 (JP); OKADA, Seiji, Tokyo 104-0061 (JP); NAKAMURA, Takahiro, Tokyo 104-0061 (JP)
(74) Representative: Novagraaf International SA
(86) International application number: PCT/JP2022/033837
(87) International publication number: WO 2023/038109

(57) **Abstract**

Object

Provided is a power generation function-equipped secondary battery that can achieve stable power generation.

Solution

A power generation function-equipped secondary battery 100 using a thermoelectric element 1 includes the thermoelectric element 1 that is in contact with a heat medium 3 indicating a temperature equal to or higher than a temperature of outside air and does not require a temperature difference between electrodes, and a secondary battery 2 electrically connected to the thermoelectric element 1, in which the thermoelectric element 1 includes a pair of electrodes 11 and 12 having work functions different from each other. For example, the thermoelectric element 1 includes an intermediate portion provided between the pair of electrodes 11 and 12 and including a non-conductor layer containing fine particles, and the non-conductor layer supports the pair of electrodes 11 and 12.

## Description

### Technical Field

This invention relates to a power generation function-equipped secondary battery using a thermoelectric element.

### Background Art

In recent years, for example, a thermoelectric charger as in Patent Document 1 has been proposed for charging a secondary battery such as a lithium ion secondary battery.

The thermoelectric charger disclosed in Patent Document 1 includes a thermoelectric element in which a ceramic substrate is embedded with a thermoelectric semiconductor and an electrode is fixed to the thermoelectric semiconductor, a first heat exchanger provided on one surface side of the thermoelectric element, a second heat exchanger provided on the other surface side of the thermoelectric element, and a means for extracting an output of the thermoelectric element to the outside.

As the thermoelectric element, other than a thermoelectric element using the Seebeck effect as in Patent Document 1, for example, a thermoelectric element or the like that does not require a temperature difference between electrodes has also been developed as in Patent Document 2.

The power generation element disclosed in Patent Document 2 is a power generation element that converts thermal energy into electric energy, and includes a first electrode, a second electrode that is provided opposite the first electrode and has a higher potential than the first electrode, and an intermediate portion provided between the first electrode and the second electrode and including a solvent having nanoparticles dispersed therein.

### Citation List

### Patent Literature

Patent Document 1: JP 11-284235 A
Patent Document 2: JP 6942404 B

### Summary of Invention

### Technical Problem

Here, the case of using the thermoelectric element using the Seebeck effect disclosed in Patent Document 1 is premised on including a configuration that generates a temperature difference between electrodes. In particular, in order to achieve continuously stable power generation using the thermoelectric element, it is necessary to maintain the temperature difference between the electrodes for a long time. In this regard, Patent Document 1 is premised on causing a temperature difference between the electrodes using metal, liquid, or the like. Therefore, since power generation is assumed to occur under a condition where the temperature difference between the electrodes is likely to change, there is a concern that unstable power generation can be caused.

On the other hand, the thermoelectric element disclosed in Patent Document 2 does not need to cause a temperature difference between the electrodes. However, when heat transferred to the thermoelectric element fluctuates over time, unstable power generation can be caused similarly to the thermoelectric element. This point is neither described nor suggested in Patent Document 2.

Therefore, the present invention has been devised in view of the above-described problems, and an object thereof is to provide a power generation function-equipped secondary battery that can achieve stable power generation.

### Solution to Problem

A power generation function-equipped secondary battery according to a first invention is a power generation function-equipped secondary battery using a thermoelectric element, the power generation function-equipped secondary battery including the thermoelectric element, the thermoelectric element being in contact with a heat medium that has a temperature equal to or higher than a temperature of outside air and not requiring a temperature difference between electrodes, and a secondary battery electrically connected to the thermoelectric element, in which the thermoelectric element includes a pair of electrodes having work functions different from each other.

In a power generation function-equipped secondary battery according to a second invention, in the first invention, the thermoelectric element includes an intermediate portion provided between the pair of electrodes and including a non-conductor layer containing fine particles, and the non-conductor layer supports the pair of electrodes.

In a power generation function-equipped secondary battery according to a third invention, in the first invention or the second invention, the pair of electrodes are sandwiched between the heat medium.

In a power generation function-equipped secondary battery according to a fourth invention, in any of the first invention to the third invention, the heat medium includes a housing portion of the secondary battery, and the thermoelectric element is provided in contact with the housing portion.

In a power generation function-equipped secondary battery according to a fifth invention, in the fourth invention, the heat medium includes a heat storage portion that stores thermal energy, and the thermoelectric element is provided in contact between the housing portion and the heat storage portion.

In a power generation function-equipped secondary battery according to a sixth invention, in any of the first invention to the fourth invention, the heat medium includes a container internally provided with the thermoelectric element and the secondary battery, and the thermoelectric element is in contact with an inner wall of the container.

In a power generation function-equipped secondary battery according to a seventh invention, in any of the first invention to the third invention, the heat medium includes a circuit board, and the thermoelectric element is in contact with the circuit board.

In a power generation function-equipped secondary battery according to an eighth invention, in the seventh invention, the thermoelectric element and the secondary battery are provided on an identical main surface of the circuit board.

In a power generation function-equipped secondary battery according to a ninth invention, in the seventh invention, the heat medium includes a housing portion of the secondary battery, and the thermoelectric element is provided in contact between the circuit board and the housing portion.

In a power generation function-equipped secondary battery according to a tenth invention, in any of the first invention to the fourth invention, the heat medium includes a drive portion supplied with electric power from the secondary battery, and the thermoelectric element is in contact with the drive portion.

### Advantageous Effects of Invention

According to the first invention to the tenth invention, the thermoelectric element is in contact with a heat medium having a temperature equal to or higher than a temperature of outside air. Therefore, it is possible to suppress fluctuation over time of heat transferred to the thermoelectric element. This makes it possible to achieve stable power generation.

In particular, according to the second invention, the intermediate portion includes a non-conductor layer containing fine particles. That is, the non-conductor layer suppresses movement of fine particles between the electrodes. Therefore, it is possible to suppress the fine particles from being unevenly distributed over time on one electrode side and the movement amount of electrons from decreasing. This makes it possible to achieve stabilization of the power generation amount.

According to the second invention, the non-conductor layer supports the pair of electrodes. Therefore, as compared with a case of using a solvent or the like in place of the non-conductor layer, it is not necessary to provide a support portion or the like for maintaining the distance (gap) between the electrodes, and can eliminate variation in the gap due to the formation accuracy of the support portion. This makes it possible to suppress variation in power generation amount.

In particular, according to the third invention, the pair of electrodes are sandwiched between the heat medium. Therefore, it is possible to further suppress fluctuation over time of heat transferred to the thermoelectric element. This makes it possible to achieve more stable power generation.

In particular, according to the fourth invention, the thermoelectric element is provided in contact with the housing portion. Therefore, thermal energy generated from the secondary battery can be converted into electric energy via the thermoelectric element. This makes it possible to achieve an increase in the power generation amount. Exhaust heat generated with use of the secondary battery can be effectively used.

In particular, according to the fifth invention, the thermoelectric element is provided in contact between the housing portion and the heat storage portion. Therefore, it is possible to easily suppress the temporal change of the thermal energy amount supplied to the thermoelectric element. This makes it possible to achieve further stabilization of the power generation amount.

In particular, according to the sixth invention, the thermoelectric element is in contact with the inner wall of the container. Therefore, the thermal energy transferred to the container can be converted into electric energy via the thermoelectric element. This makes it possible to achieve an increase in the power generation amount.

In particular, according to the seventh invention, the thermoelectric element is in contact with the circuit board. Therefore, thermal energy generated on the circuit board by arithmetic processing or the like can be converted into electric energy via the thermoelectric element. This makes it possible to achieve an increase in the power generation amount. Exhaust heat generated with arithmetic processing or the like can be effectively used.

In particular, according to the eighth invention, the thermoelectric element and the secondary battery are provided on an identical main surface of the circuit board. Therefore, it is possible to suppress thermal energy generated from the secondary battery from being retained in the circuit board. This makes it possible to suppress quality deterioration such as deterioration of the circuit board and calculation speed decrease.

In particular, according to the ninth invention, the thermoelectric element is provided in contact between the circuit board and the housing portion. Therefore, it is possible to suppress thermal energy generated from the secondary battery from being directly transferred to the circuit board. This makes it possible to suppress quality deterioration such as deterioration of the circuit board and calculation speed decrease.

In particular, according to the tenth invention, the thermoelectric element is in contact with the drive portion. Therefore, thermal energy generated from the drive portion can be converted into electric energy via the thermoelectric element. This makes it possible to achieve an increase in the power generation amount. Exhaust heat generated from the drive portion can be effectively used.

### Brief Description of Drawings

FIG. 1 is a schematic diagram illustrating an example of a power generation function-equipped secondary battery in an embodiment.
FIG. 2(a) is a schematic diagram illustrating a first modification example of the power generation function-equipped secondary battery in the embodiment, and FIG. 2(b) is a schematic diagram illustrating a third modification example of the power generation function-equipped secondary battery in the embodiment.
FIGS. 3(a) and 3(b) are schematic diagrams illustrating a fourth modification example of the power generation function-equipped secondary battery in the embodiment.
FIG. 4 is a conceptual diagram illustrating an example of a power generation system in the embodiment.
FIG. 5(a) is a schematic cross-sectional view illustrating an example of a thermoelectric element in the embodiment, and FIG. 5(b) is a schematic cross-sectional view taken along line A-A in FIG. 5(a).
FIG. 6 is a schematic cross-sectional view illustrating an example of an intermediate portion.
FIG. 7(a) is a schematic cross-sectional view illustrating a first modification example of the thermoelectric element in the embodiment, and FIG. 7(b) is a schematic cross-sectional view illustrating a second modification example of the thermoelectric element in the embodiment.
FIG. 8 is a schematic cross-sectional view illustrating a first modification example of the intermediate portion.
FIG. 9 is a schematic cross-sectional view illustrating a second modification example of the intermediate portion.

### Description of Embodiments

Hereinafter, an example of a power generation function-equipped secondary battery and a power generation system as an embodiment of the present invention will be described with reference to the drawings. In each drawing, a height direction in which each electrode of the thermoelectric element is layered is a first direction Z, one planar direction intersecting, for example, orthogonal to, the first direction Z is a second direction X, and another planar direction intersecting, for example, orthogonal to, each of the first direction Z and the second direction X is a third direction Y. The configuration in each drawing is schematically described for the sake of explanation, and for example, the size of each configuration, comparison in size in each configuration, and the like may be different from those in the drawings.

### Power generation function-equipped secondary battery 100

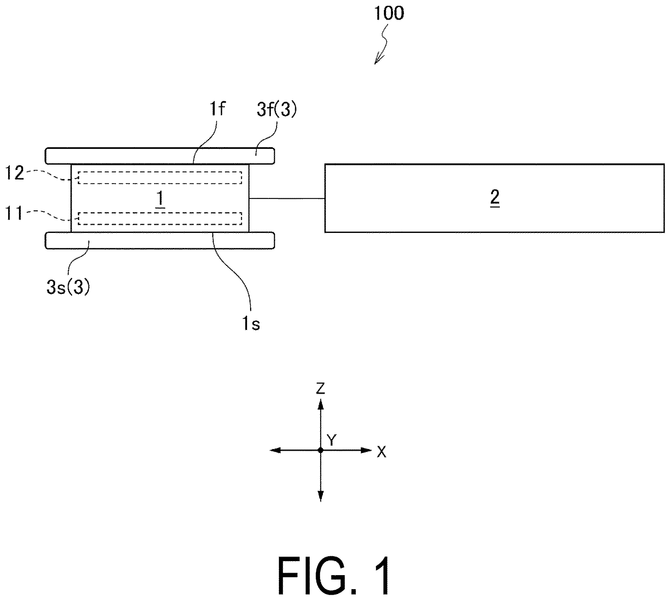

FIG. 1 is a schematic diagram illustrating an example of a power generation function-equipped secondary battery 100 in the present embodiment.

The power generation function-equipped secondary battery 100 is electrically connected to a known device requiring a power source, such as an electronic device, an electric vehicle, and a self-contained sensor terminal. The power generation function-equipped secondary battery 100 is used not only as a main power source but also as an auxiliary power source, for example.

The power generation function-equipped secondary battery 100 includes a thermoelectric element 1 and a secondary battery 2. The thermoelectric element 1 converts thermal energy into electric energy. The secondary battery 2 is electrically connected to the thermoelectric element 1, and is electrically connected to a drive portion that is driven by supply of electric power, for example. The drive portion refers to an arithmetic processing device such as a central processing unit (CPU), for example, or a known drive device such as a motor.

The thermoelectric element 1 includes a pair of electrodes 11 and 12 having work functions different from each other. In this case, when thermal energy is converted into electric energy, a temperature difference between the electrodes becomes unnecessary. For example, the thermoelectric element 1 has a first surface 1f and a second surface 1s that intersect with the first direction Z, the first electrode 11 is provided on the first surface 1f side, and the second electrode 12 is provided on the second surface 1s side. Between the first electrode 11 and the first surface 1f, and between the second electrode 12 and the second surface 1s, for example, a member such as a substrate and a housing may be provided, and in addition, for example, a cavity or the like may be provided. Other than the above, for example, in the thermoelectric element 1, the surface of the first electrode 11 may be the first surface 1f, and the surface of the second electrode 12 may be the second surface 1s.

Here, when the secondary battery 2 is charged using a known thermoelectric element whose power generation amount is unstable, there is a possibility of causing an unexpected defect such as an overcharged state, and early deterioration of the secondary battery 2 is a concern. On the other hand, in the power generation function-equipped secondary battery 100 in the present embodiment, the thermoelectric element 1 is in contact with a heat medium 3 having a temperature equal to or higher than a temperature of outside air. Therefore, it is possible to suppress fluctuation over time of heat transferred to the thermoelectric element 1. This makes it possible to achieve stable power generation. Therefore, it is possible to lead to suppression of early deterioration of the secondary battery 2, for example. For example, as illustrated in FIG. 1, the first surface 1f and the second surface 1s of the thermoelectric element 1 may be in contact with the heat medium 3, or at least any of the first surface 1f, the second surface 1s, and a side surface may be in contact with the heat medium 3.

For example, the pair of electrodes 11 and 12 may be sandwiched between the heat medium 3. In this case, it is possible to further suppress fluctuation over time of heat transferred to the thermoelectric element 1. In particular, the fluctuation of the heat transferred to each of the electrodes 11 and 12 is suppressed, and variation in temperature difference between the electrodes 11 and 12 can be made difficult to occur. This makes it possible to achieve more stable power generation. As illustrated in FIG. 1, for example, the entire thermoelectric element 1 may be sandwiched by the heat medium 3, or, for example, at least a part of the thermoelectric element 1 may be sandwiched by the heat medium 3. The state in which the pair of electrodes 11 and 12 and the like are "sandwiched" by the heat medium 3 not only indicates a state in which the pair of electrodes 11 and 12 and the like are in contact with the heat medium 3 but also may indicate a separated state, for example.

The pair of electrodes 11 and 12 are sandwiched between a first heat medium 3f and a second heat medium 3s along the first direction Z in which the main surfaces face each other, for example. The pair of electrodes 11 and 12 may be sandwiched between the first heat medium 3f and the second heat medium 3s along the second direction X or the third direction Y parallel to the main surface, for example. In any case, thermal energy can be continuously supplied from each of the heat mediums 3f and 3s to each of the electrodes 11 and 12. In particular, use of the thermoelectric element 1 not requiring a temperature difference between the electrodes can eliminate the need for consideration of the degree of thermal energy supplied from each of the heat mediums 3f and 3s, making it possible to easily achieve continuous, stable power generation. The thermoelectric element 1 will be described later in detail.

The secondary battery 2 is a known battery that can be charged and discharged, such as a lithium ion secondary battery. The secondary battery 2 can be charged based on power generated by the thermoelectric element 1, for example. The type, performance, and the like of the secondary battery 2 can be arbitrarily selected depending on the application.

The heat medium 3 may be any structure that has a temperature equal to or higher than a temperature of outside air, and may be a heat source that generates thermal energy, for example. The heat medium 3 may include the first heat medium 3f and the second heat medium 3s provided separately, or may include the first heat medium 3f and the second heat medium 3s provided integrally, for example.

Examples of the heat source include an electronic component of an electronic device such as a CPU, a light emitting element such as a light emitting diode (LED), an engine of an automobile or the like, a production facility of a factory, a human body, sunlight, and an environmental temperature. Examples of the heat medium 3 include, in addition to the heat source described above, a structure that can store heat, such as a housing of an electronic device or the like, an exhaust heat pipe, a glass or frame portion of a solar panel, and a vehicle body of an automobile.

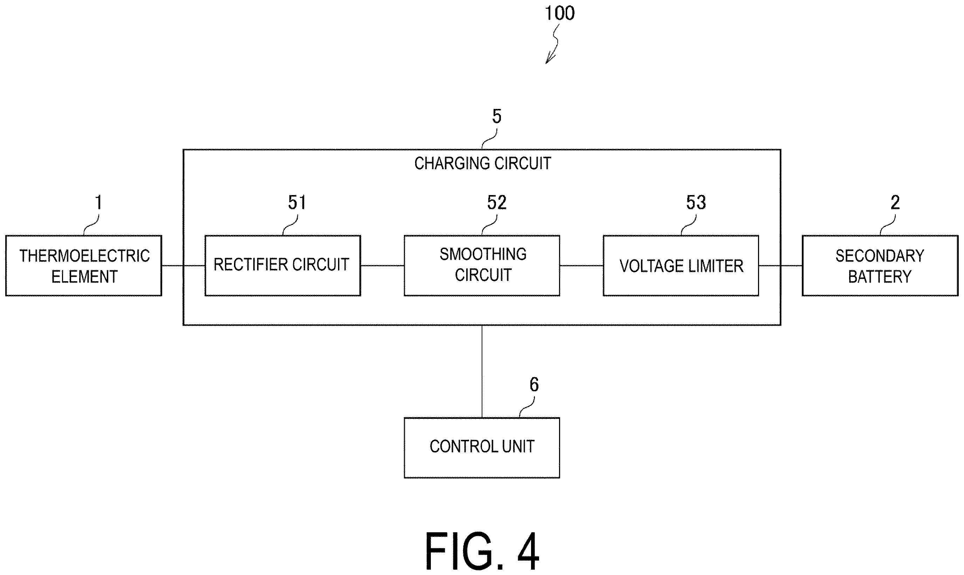

The power generation function-equipped secondary battery 100 includes a charging circuit 5 as illustrated in FIG. 4, for example. As the charging circuit 5, a known circuit used when the secondary battery 2 is charged using energy harvesting, such as the thermoelectric element 1, for example, is used. The charging circuit 5 includes, for example, a rectifier circuit 51, a smoothing circuit 52, and a voltage limiter 53. The charging circuit 5 may include a booster circuit, for example.

The rectifier circuit 51 is used in a case where the polarity of the voltage output from the thermoelectric element 1, for example, changes. The smoothing circuit 52 is used in a case of smoothing a direct-current voltage output from the thermoelectric element 1 or the rectifier circuit 51, for example. The voltage limiter 53 is used in a case of suppressing the secondary battery 2, for example, from being applied with an excessive voltage.

### First modification example: heat medium 3 includes housing portion 21 of secondary battery 2

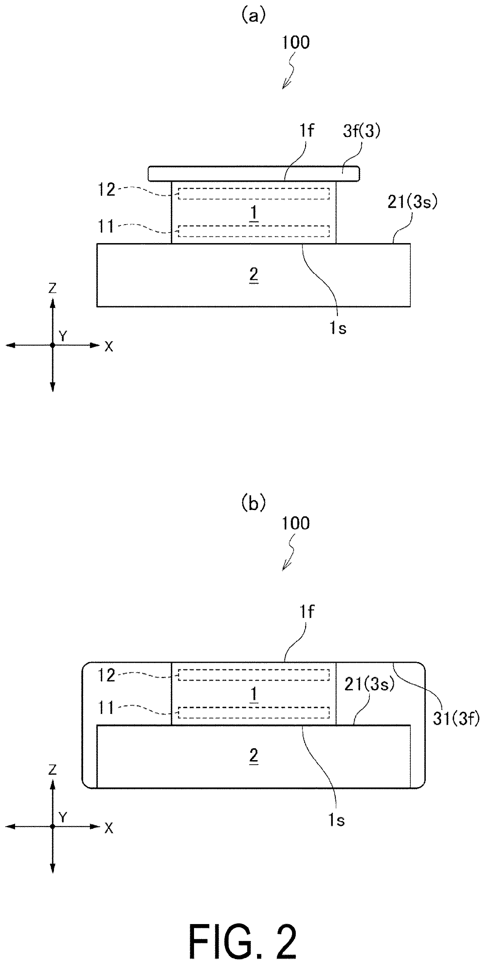

For example, the heat medium 3 may include a housing portion 21 of the secondary battery 2. In this case, for example, as illustrated in FIG. 2(a), the thermoelectric element 1 may be provided in contact with the housing portion 21. That is, the pair of electrodes 11 and 12 are sandwiched between the arbitrary first heat medium 3f and the housing portion 21 corresponding to the second heat medium 3s. Therefore, thermal energy generated from the secondary battery 2 can be converted into electric energy via the thermoelectric element 1. This makes it possible to achieve an increase in the power generation amount. Exhaust heat generated with use of the secondary battery 2 can be effectively used.

The temperature of the housing portion 21 increases with charging and discharging of the secondary battery 2, and is continuously prone to have a temperature higher than a temperature of outside air. Therefore, use of the housing portion 21 as the heat medium 3 enables stable supply of thermal energy to the thermoelectric element 1.

As the housing portion 21, a known secondary battery housing is used, and for example, a material having high thermal conductivity is used. A container 31 may be internally provided with not only the electrode and an active material of the secondary battery 2 but also, for example, an arbitrary electronic member, a sealing material, and the like.

For example, the thermoelectric element 1 may be provided between a pair of the secondary batteries 2. That is, the pair of electrodes 11 and 12 may be sandwiched between the housing portion 21 of one secondary battery 2 corresponding to the first heat medium 3f and the housing portion 21 of the other secondary battery 2 corresponding to the second heat medium 3s. Also in this case, thermal energy generated from the secondary battery 2 can be converted into electric energy via the thermoelectric element 1. This makes it possible to achieve an increase in the power generation amount.

### Second modification example: heat medium 3 includes heat storage portion

For example, the heat medium 3 may include a heat storage portion that stores thermal energy. In this case, the thermoelectric element 1 is provided in contact between the heat storage portion and the housing portion 21. That is, the pair of electrodes 11 and 12 are sandwiched between the heat storage portion corresponding to the first heat medium 3f and the housing portion 21 corresponding to the second heat medium 3s. Therefore, it is possible to easily suppress the temporal change of the thermal energy amount supplied to the thermoelectric element 1. This makes it possible to achieve further stabilization of the power generation amount.

The heat storage portion has a known sensible heat storage material using specific heat of a substance, for example. As the sensible heat storage material, for example, aerogel, brick, or the like is used. The aerogel has a nanosize porosity smaller than the mean free path of air molecules, and is made with a material such as silica, carbon, and alumina. As the sensible heat storage material, for example, a material exhibiting specific heat higher than specific heat of glass (e.g., 0.67 J/g K when 10 to 50 °C) is used. As the value of specific heat, a measurement result according to JIS K 7123 may be used in addition to reference to a literature value.

The heat storage portion may have a latent heat storage material using, for example, a phase change of a substance and transition heat (latent heat) accompanying a transition. As the latent heat storage material, a known material using a phase change of water, sodium chloride, or the like is used. The heat storage portion may have a chemical heat storage material using endothermic heat generation at the time of a chemical reaction, for example. As the chemical heat storage material, for example, a known material is used.

For example, the thermoelectric element 1 may be provided in contact between a pair of heat storage portions. That is, the pair of electrodes 11 and 12 may be sandwiched between one heat storage portion corresponding to the first heat medium 3f and the other heat storage portion corresponding to the second heat medium 3s. Also in this case, it is possible to easily suppress the temporal change of the thermal energy amount supplied to the thermoelectric element 1. This makes it possible to achieve further stabilization of the power generation amount.

In addition to the above, for example, the thermoelectric element 1 may be provided in a state of being contained in the heat storage portion. Also in this case, it is possible to easily suppress the temporal change of the thermal energy amount supplied to the thermoelectric element 1. This makes it possible to achieve further stabilization of the power generation amount. In particular, a temperature difference hardly occurs in a region where the thermoelectric element 1 is contained in the heat storage portion. Therefore, a temperature difference hardly occurs between the electrodes 11 and 12, and it becomes possible to suppress variation in power generation due to the temperature difference between the electrodes.

### Third modification example: heat medium 3 includes container 31

For example, the heat medium 3 may include the container 31 internally provided with the thermoelectric element 1 and the secondary battery 2. In this case, the thermoelectric element 1 is in contact with an inner wall of the container 31. That is, the pair of electrodes 11 and 12 are sandwiched by the inner wall of the container 31 corresponding to the heat medium 3. Therefore, thermal energy transferred to the container 31 can be converted into electric energy via the thermoelectric element 1. This makes it possible to achieve an increase in the power generation amount.

For example, as illustrated in FIG. 2(b), the thermoelectric element 1 may be in contact with the inner wall of the container 31 and the housing portion 21. That is, the pair of electrodes 11 and 12 may be sandwiched between the inner wall of the container 31 corresponding to the first heat medium 3f and the housing portion 21 corresponding to the second heat medium 3s. Also in this case, thermal energy transferred to the container 31 and the housing portion 21 can be converted into electric energy via the thermoelectric element 1. This makes it possible to achieve an increase in the power generation amount.

As the container 31, a known material for protecting electronic components and the like is used, and for example, a material having high thermal conductivity is used. The container 31 may be internally provided with, for example, not only the thermoelectric element 1 and the secondary battery 2 but also an arbitrary electronic member, a sealing material, and the like.

### Fourth modification example: heat medium 3 includes circuit board 4

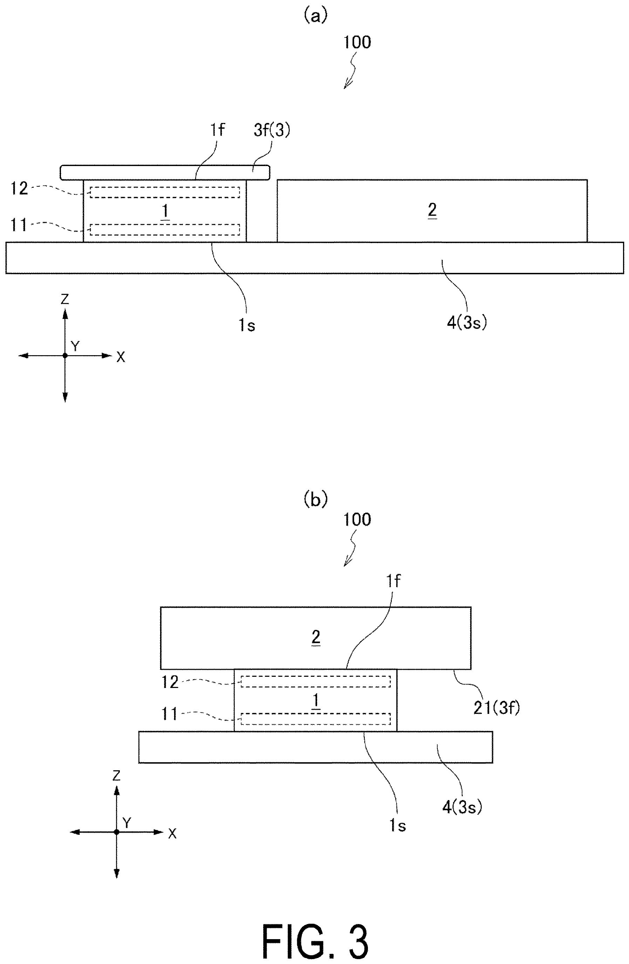

For example, the heat medium 3 may include the circuit board 4. In this case, for example, as illustrated in FIG. 3(a), the thermoelectric element 1 is in contact with the circuit board 4. That is, the pair of electrodes 11 and 12 are sandwiched between the arbitrary first heat medium 3f and the circuit board 4 corresponding to the second heat medium 3s. Therefore, thermal energy generated on the circuit board 4 by arithmetic processing or the like can be converted into electric energy via the thermoelectric element 1. This makes it possible to achieve an increase in the power generation amount. Exhaust heat generated with arithmetic processing or the like can be effectively used.

For example, the thermoelectric element 1 and the secondary battery 2 may be provided on an identical main surface of the circuit board 4. In this case, it is possible to easily supply the thermal energy generated from the secondary battery 2 to the thermoelectric element 1 via the circuit board 4, and it is possible to suppress thermal energy from being retained in the circuit board 4. This makes it possible to suppress quality deterioration such as deterioration of the circuit board 4 and calculation speed decrease.

For example, as illustrated in FIG. 3(b), the thermoelectric element 1 may be provided in contact between the circuit board 4 and the housing portion 21. That is, the pair of electrodes 11 and 12 are sandwiched between the housing portion 21 corresponding to the first heat medium 3f and the circuit board 4 corresponding to the second heat medium 3s. Therefore, it is possible to suppress thermal energy generated from the secondary battery 2 from being directly transferred to the circuit board 4. This makes it possible to suppress quality deterioration such as deterioration of the circuit board 4 and calculation speed decrease.

The circuit board 4 is a known wiring-equipped board mounted with electronic components such as a CPU and a transistor. The size and type of the circuit board 4 can be arbitrarily set depending on the application. For example, the charging circuit 5 described above may be disposed on the circuit board 4.

### Power generation system

Next, an example of a power generation system in the present embodiment will be described. FIG. 4 is a conceptual diagram illustrating an example of a power generation system in the present embodiment.

For example, as illustrated in FIG. 4, the power generation system includes the power generation function-equipped secondary battery 100 and a control unit 6. The power generation function-equipped secondary battery 100 may include, for example, a plurality of the thermoelectric elements 1 or a plurality of the secondary batteries 2.

The control unit 6 includes a known arithmetic processing device such as a CPU, for example, and is mounted on an electronic device such as a personal computer or a smartphone, for example. The control unit 6 may include, for example, a sensor such as a current measurement sensor, a voltage measurement sensor, or a temperature sensor, and measure a measurement value. The control unit 6 may include, for example, a storage unit that saves a preset threshold value or the like.

The control unit 6 controls a charging condition of the secondary battery 2 charged via the thermoelectric element 1. Therefore, the charging condition can be controlled based on the charging and discharging state of the secondary battery 2 and the power generation state of the thermoelectric element 1. This makes it possible to achieve suppression of early deterioration of the secondary battery 2.

The control unit 6 acquires, as a measurement value, at least any of a voltage and a current based on power generation of the thermoelectric element 1, for example. The control unit 6 may acquire a measurement value corresponding to each of the plurality of thermoelectric elements 1, for example.

The control unit 6 controls the charging condition of the secondary battery 2 based on the measurement value. The control unit 6 may control a control condition for each of the one or more secondary batteries 2 based on, for example, one or more measurement values. The charging condition can be arbitrarily set in advance, for example, and can be arbitrarily set as long as the condition affects the charging of the secondary battery 2.

For example, when the charging circuit 5 includes a plurality of the voltage limiters 53, the charging condition includes a connection condition to the voltage limiters 53 in accordance with the measurement value. That is, the control unit 6 can control the charging condition by electrically connecting a specific voltage limiter 53 to the secondary battery 2 and electrically separating another voltage limiter 53 from the secondary battery 2, based on the measurement value.

For example, the control unit 6 may acquire, as a measurement value, a temperature of the thermoelectric element 1 at the time of power generation. In this case, for example, the control unit 6 may control the temperature of the thermoelectric element 1 based on a result of comparison between a preset temperature threshold value and a measurement value. By controlling the temperature of the thermoelectric element 1, it is possible to change the power generation amount of the thermoelectric element 1, and therefore it is possible to control a charging condition of the secondary battery 2.

For example, when the temperature at the time of power generation of the thermoelectric element 1 is acquired as the measurement value, the control unit 6 may calculate an estimated power generation amount corresponding to the measurement value, and control the charging condition based on the calculation result. Other than the above, for example, the control unit 6 may acquire a temporal change in temperature at the time of power generation of the thermoelectric element 1 as a measurement value. In this case, the control unit 6 may control a charging condition for interrupting charging of the secondary battery 2 in a case where a temperature change exceeding a threshold value occurs.

For example, the thermoelectric element 1 may include a plurality of elements each independently electrically connected to the secondary battery 2. In this case, the control unit 6 may control, as a charging condition, the electrical connection relationship between the secondary battery 2 and the plurality of elements. For example, the control unit 6 acquires, as a measurement value, a voltage for each of the plurality of elements. Thereafter, based on the measurement value, the control unit 6 selects an element that can output a voltage suitable for the charging state of the secondary battery 2, and electrically connects the selected element and the secondary battery 2.

For example, the control unit 6 calculates a voltage suitable for the charging state of the secondary battery 2 using the discharge rate characteristic of the secondary battery 2 acquired in advance. Thereafter, from the measurement values acquired from the plurality of elements, the control unit 6 specifies an element that can output the calculated voltage, and electrically connects the element and the secondary battery 2. The control unit 6 may connect a plurality of elements in parallel or in series, for example.

For example, the secondary battery 2 may be electrically connected to the drive portion, for example, and the thermoelectric element 1 may be electrically separated from the drive portion. In this case, the control unit 6 may control a condition of electric power supplied from the secondary battery 2 to the drive portion. The control unit 6 acquires, via the above-described sensor, supply information (e.g., voltage or current) related to electric power supplied from, for example, the secondary battery 2 to the drive portion. Based on the supply information, the control unit 6 controls the condition of the electric power supplied from the secondary battery 2 to the drive portion by a similar method to the charging condition described above.

For example, the secondary battery 2 and the thermoelectric element 1 may be electrically connected to the drive portion. In this case, similarly to the above, for example, the control unit 6 may control the condition of electric power supplied from the thermoelectric element 1 to the drive portion. For example, the control unit 6 may control a condition of electric power supplied from the secondary battery 2 and the thermoelectric element 1 to the drive portion. Also in this case, similarly to the method described above, the control unit 6 can acquire supply information related to electric power supplied from the thermoelectric element 1 and the secondary battery 2 to the drive portion, and control the condition of the electric power based on the supply information.

### Thermoelectric element 1

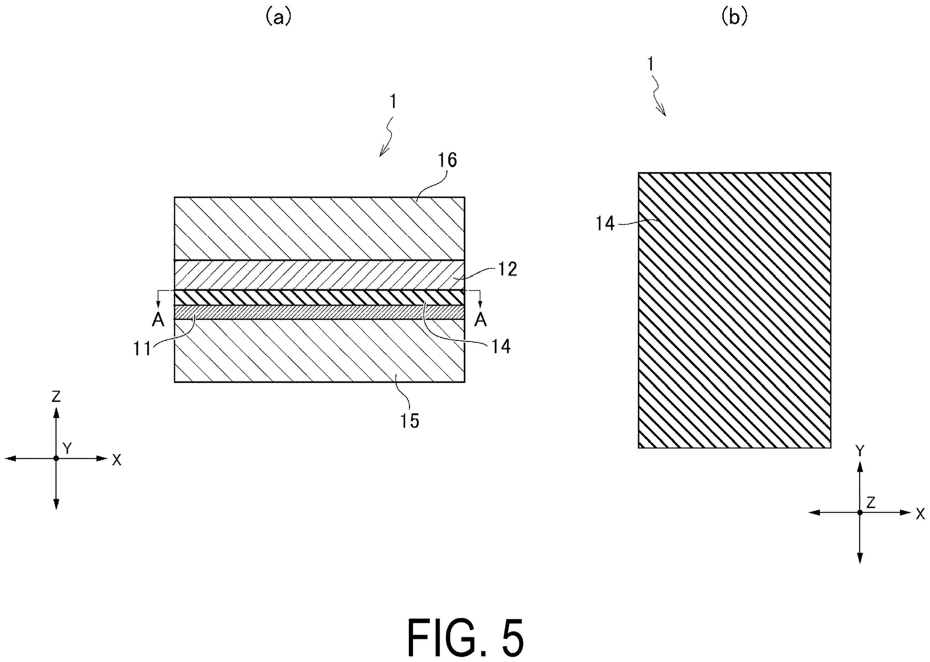

FIG. 5(a) is a schematic cross-sectional view illustrating an example of the thermoelectric element 1 in the present embodiment, and FIG. 5(b) is a schematic cross-sectional view taken along line A-A in FIG. 5(a).

As illustrated in FIG. 5(a), for example, the thermoelectric element 1 includes the first electrode 11, the second electrode 12, and an intermediate portion 14. The thermoelectric element 1 may include at least any of, for example, a first substrate 15 and a second substrate 16.

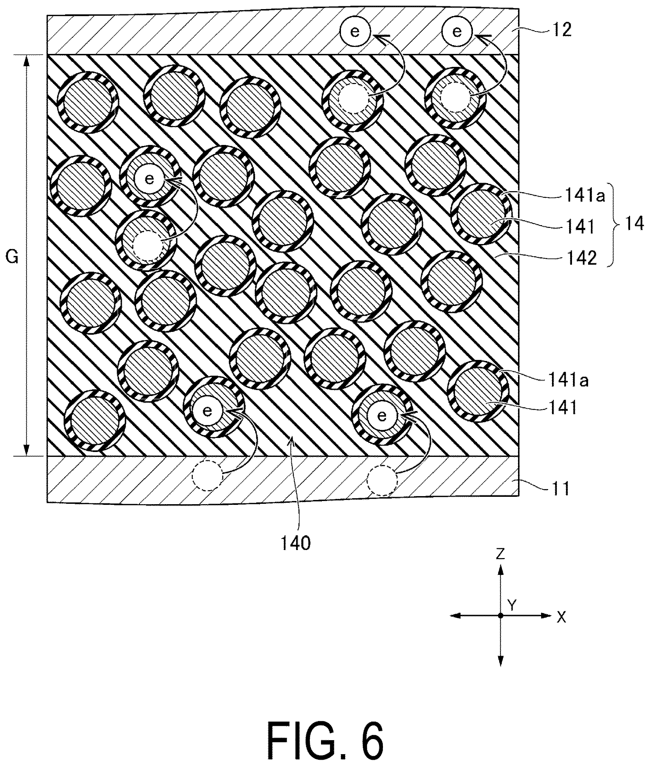

The first electrode 11 and the second electrode 12 are provided facing each other. The first electrode 11 and the second electrode 12 have work functions different from each other. For example, as illustrated in FIG. 6, the intermediate portion 14 is provided in a space 140 including a space (gap G) between the first electrode 11 and the second electrode 12. The intermediate portion 14 includes fine particles 141.

The fine particles 141 may include, for example, first fine particles 141f and second fine particles 141s. For example, a median diameter D50s of the second fine particle 141s is smaller than a median diameter D50f of the first fine particle 141f. In this case, it is possible to increase the possibility that, for example, the second fine particles 141s enter between the particles of the first fine particles 141f. At this time, a range where the fine particles 141f and 141s can fluctuate becomes narrower than that in a case where only any one of the fine particles 141f and 141s are included in the intermediate portion 14. Therefore, fluctuation of the fine particles 141 can be suppressed. This makes it possible to suppress a decrease in power generation amount.

For example, since the fine particles 141 include the fine particles 141f and 141s, the area of the fine particles 141 in contact with each of the electrodes 11 and 12 can be increased as compared with the case of including only the first fine particles 141f having the large median diameter D50f. Therefore, the amount of electrons moving between the electrodes 11 and 12 can be increased. This makes it possible to achieve an increase in the power generation amount.

For example, since the fine particles 141 include the fine particles 141f and 141s, the filling degree of the fine particles 141 in the intermediate portion 14 can be easily improved as compared with the case of including only the second fine particles 141s having the small median diameter D50s. This makes it possible to smooth movement of electrons between the fine particles 141. Also in this respect, it is possible to achieve an increase in the power generation amount.

Hereinafter, details of each configuration will be described.

### First electrode 11 and second electrode 12

The first electrode 11 and the second electrode 12 are separated in the first direction Z as illustrated in FIG. 5(a), for example. A plurality of the electrodes 11 and 12 may be provided extending in, for example, the second direction X and the third direction Y. For example, one second electrode 12 may be provided facing the plurality of the first electrodes 11 at positions different from one another. For example, one first electrode 11 may be provided facing the plurality of the second electrodes 12 at positions different from one another.

As a material of the first electrode 11 and the second electrode 12, a material having conductivity is used. As the materials of the first electrode 11 and the second electrode 12, for example, materials having work functions different from each other are used. The identical material may be used for each of the electrodes 11 and 12, and in this case, the electrodes may have work functions different from each other.

As the material of each of the electrodes 11 and 12, for example, a material including a single element such as iron, aluminum, or copper, or a material of an alloy including two or more types of elements may be used. For example, a nonmetallic conductive material may be used as the material of each of the electrodes 11 and 12. Examples of the nonmetallic conductive material include silicon (Si: for example, p-type Si or n-type Si), and a carbon-based material such as graphene.

The thicknesses of the first electrode 11 and the second electrode 12 along the first direction Z are, for example, equal to or greater than 4 nm and equal to or less than 1 µm . The thicknesses of the first electrode 11 and the second electrode 12 along the first direction Z may be, for example, equal to or greater than 4 nm and equal to or less than 500 nm.

The gap G indicating the distance between the first electrode 11 and the second electrode 12 can be arbitrarily set by changing the thickness of a non-conductor layer 142, for example. For example, by narrowing the gap G, it is possible to increase an electric field generated between the electrodes 11 and 12, and therefore it is possible to increase the power generation amount of the thermoelectric element 1. For example, by narrowing the gap G, it is possible to thin the thickness along the first direction Z of the thermoelectric element 1.

The gap G is a finite value of equal to or less than 500 µm, for example. The gap G is, for example, equal to or greater than 10 nm and equal to or less than 1 µm. For example, when the gap G is equal to or less than 200 nm, there is a high possibility that the first electrode 11 and the second electrode 12 come into contact with each other. When the gap G is greater than 1 µm, there is a possibility that the electric field generated between the electrodes 11 and 12 is weakened. Therefore, the gap G is preferably greater than 200 nm and equal to or less than 1 µm .

### Intermediate portion 14

The intermediate portion 14 includes, for example, the fine particles 141 and the non-conductor layer 142. The non-conductor layer 142 contains the fine particles 141 and supports the first electrode 11 and the second electrode 12. In this case, the non-conductor layer 142 suppresses movement of the fine particles 141 in the gap G. Therefore, it is possible to suppress the fine particles 141 from being unevenly distributed over time on one electrode 11, 12 side and the movement amount of electrons from decreasing. This makes it possible to achieve stabilization of the power generation amount.

The non-conductor layer 142 is formed by curing a non-conductor material, for example. The non-conductor layer 142 indicates, for example, a solid. The non-conductor layer 142 may include, for example, a residue of a diluent or an uncured part of a non-conductor material. Also in this case, similarly to the above, it becomes possible to achieve stabilization of the power generation amount. The fine particles 141 are fixed in a state of being dispersed in the non-conductor layer 142, for example. Also in this case, similarly to the above, it becomes possible to achieve stabilization of the power generation amount.

The intermediate portion 14 is provided on the first electrode 11. The second electrode 12 is provided on the non-conductor layer 142. Here, when thermal energy is converted into electric energy, in the thermoelectric element 1 not requiring a temperature difference between the electrodes, for example, an increase in the power generation amount can be achieved by suppressing the variation of the gap G in the surface along the second direction X and the third direction Y. In this regard, when a liquid such as a solvent is used as the intermediate portion, it is necessary to provide a support portion or the like for maintaining the gap G. However, there has been a concern that the variation of the gap G can be increased with formation of the support portion or the like. On the other hand, in the thermoelectric element 1 in the present embodiment, since the second electrode 12 is provided on the non-conductor layer 142, it is not necessary to provide a support portion or the like for maintaining the gap G between the electrodes, making it possible to eliminate variation in the gap due to the formation accuracy of the support portion or the like. This makes it possible to suppress variation in power generation amount.

When a support portion or the like for maintaining the gap is provided, there is a concern that the fine particles 141 come into contact with the support portion and aggregate around the support portion. On the other hand, the thermoelectric element 1 of the present embodiment can remove a state in which the fine particles 141 are aggregated due to the support portion. This makes it possible to maintain a stable power generation amount.

For example, as illustrated in FIG. 5(b), the intermediate portion 14 extends in a plane along the second direction X and the third direction Y. The intermediate portion 14 is provided in the space 140 formed between the electrodes 11 and 12. The intermediate portion 14 may be in contact with the main surfaces of the electrodes 11 and 12 facing each other, and may be in contact with side surfaces of the electrodes 11 and 12, for example.

The fine particles 141 may be dispersed in the non-conductor layer 142, and for example, a part thereof may be exposed from the non-conductor layer 142. The fine particles 141 may be filled in the gap G, for example, and the non-conductor layer 142 may be provided in the gap between the fine particles 141. The particle size of the fine particles 141 is, for example, smaller than the gap G. The particle size of the fine particles 141 is a finite value of equal to or less than 1/10 of the gap G, for example. When the particle size of the fine particles 141 is equal to or less than 1/10 of the gap G, it becomes easy to form the intermediate portion 14 containing the fine particles 141 in the space 140. This makes it possible to improve workability when thermoelectric element 1 is produced.

Here, the "fine particles" refer to those containing a plurality of particles. The fine particles 141 include, for example, particles having a particle size of equal to or greater than 2 nm and equal to or less than 1000 nm. The fine particles 141 may include particles of which, for example, the median diameter (D50) has a particle size of equal to or greater than 3 nm and equal to or less than 20 nm, and may include particles of which, for example, the mean particle size has a particle size of equal to or greater than 3 nm and equal to or less than 20 nm. The particle number concentration of the fine particles 141 may be, for example, about 1.0 × 10⁶ to 1.0 × 10¹² particles/ml, and can be arbitrarily set depending on the application. The median diameter or the mean particle size and the particle number concentration can be measured by using a particle size distribution measuring instrument, for example. As the particle size distribution measuring instrument, for example, a particle size distribution measuring instrument using a dynamic light scattering method (e.g., Zetasizer Ultra manufactured by Malvern Panalytical Ltd) may be used.

The first fine particles 141f and the second fine particles 141s contained in the fine particles 141 can be arbitrarily selected as long as they fall within the above-described particle size range, for example. A difference between the median diameter D50f of the first fine particles 141f and the median diameter D50s of the second fine particles 141s is arbitrary.

For example, the particle number concentration of the first fine particles 141f is lower than the particle number concentration of the second fine particles 141s. Here, when the particle number concentration of the first fine particles 141f is higher than the particle number concentration of the second fine particles 141s, the possibility that the second fine particles 141s enter between the particles of the first fine particles 141f becomes low. Therefore, the filling degree of the fine particles 141 between the electrodes 11 and 12 cannot be increased, and there is a concern that uneven distribution of the fine particles 141 and the like is caused. On the other hand, according to the present embodiment, for example, the particle number concentration of the first fine particles 141f is lower than the particle number concentration of the second fine particles 141s. In this case, it is possible to increase the filling degree of the fine particles 141 between the electrodes 11 and 12. Therefore, it becomes possible to suppress uneven distribution or the like of the fine particles 141.

For example, the work function of the first fine particles 141f is lower than the work function of the second fine particles 141s. In this case, electrons easily move from the first electrode 11 and the first fine particles 141f toward the second fine particles 141s. Since the inter-particle distance of the second fine particles 141s tends to be shorter than the inter-particle distance of the first fine particles 141f, a transfer path of electrons in the intermediate portion 14 is easily formed. Therefore, electrons are easily supplied from the first electrode 11 to the intermediate portion 14 via the second fine particles 141s. This makes it possible to smoothly proceed with transfer of electrons between the electrodes 11 and 12. Therefore, it becomes possible to achieve an increase in the power generation amount.

The fine particles 141 include, for example, a conductive material, and an arbitrary material is used depending on the application. The fine particles 141 may contain one type of material or may contain a plurality of materials depending on the application.

The fine particles 141 contain, for example, a metal. As the fine particles 141, for example, particles containing one type of material such as gold or silver or particles of an alloy containing, for example, two or more types of materials may be used.

The fine particles 141 contain, for example, a metal oxide. As the fine particles 141 containing a metal oxide, a metal oxide of at least any one element selected from the group consisting of a metal and Si, such as, for example, zirconia (ZrO₂), titania (TiO₂), silica (SiO₂), alumina (Al₂O₃), iron oxide (Fe₂O₃, Fe₂O₅), copper oxide (CuO), zinc oxide (ZnO), yttria (Y₂O₃), niobium oxide (Nb₂O₅), molybdenum oxide (MoOs), indium oxide (In₂O₃), tin oxide (SnO₂), tantalum oxide (Ta₂O₅), tungsten oxide (WO₃), lead oxide (PbO), bismuth oxide (Bi₂O₃), ceria (CeC₂), and antimony oxide (Sb₂O₅, Sb₂O₃), is used. The fine particles 141 may contain, for example, a dielectric.

The fine particles 141 may contain, for example, a metal oxide excluding a magnetic body. For example, in a case that fine particles 141 contain a metal oxide indicating a magnetic body, movement of the fine particles 141 can be restricted by the magnetic field generated due to the environment in which thermoelectric element 1 is disposed. Therefore, since the fine particles 141 contain a metal oxide excluding a magnetic body, it is possible to suppress a decrease over time in the power generation amount without being affected by the magnetic field caused by an external environment.

The fine particles 141 include, for example, a coating 141a on the surface. The thickness of the coating 141a is a finite value of equal to or less than 20 nm, for example. By providing the coating 141a on the surface of the fine particles 141, it is possible to suppress aggregation when dispersing in the non-conductor layer 142, for example. By providing the coating 141a on the surface of the fine particles 141, it becomes possible to prevent the fine particles 141 from coming into direct contact with at least any of the first electrode 11 and the second electrode 12.

As the coating 141a, for example, a material having a thiol group or a disulfide group is used. As a material having a thiol group, for example, alkanethiol such as dodecanethiol is used. As a material having a disulfide group, for example, alkane disulfide or the like is used.

The non-conductor layer 142 is provided between the electrodes 11 and 12, and is in contact with, for example, the electrodes 11 and 12. The thickness of the non-conductor layer 142 is a finite value of equal to or less than 500 µm, for example. The thickness of the non-conductor layer 142 affects the value and variation of the gap G described above. Therefore, for example, when the thickness of the non-conductor layer 142 is equal to or less than 200 nm, the possibility that the first electrode 11 and the second electrode 12 come into contact with each other increases. When the thickness of the non-conductor layer 142 is greater than 1 µm, there is a possibility that the electric field generated between the electrodes 11 and 12 is weakened. For these reasons, the thickness of the non-conductor layer 142 is preferably greater than 200 nm and equal to or less than 1 µm .

The non-conductor layer 142 contains, for example, one type of material or may contain a plurality of materials depending on the application. As the non-conductor layer 142, a material described in, for example, ISO 1043-1 or JIS K 6899-1 may be used. The non-conductor layer 142 includes a plurality of layers containing different materials, for example, and may include a configuration in which the layers are layered. In a case where the non-conductor layer 142 includes a plurality of layers, for example, each layer may contain (e.g., disperse) the fine particles 141 containing different materials from each other.

The non-conductor layer 142 has, for example, an insulating property. The material used for the non-conductor layer 142 is arbitrary as long as it is a non-conductor material that can fix the fine particles 141 in a dispersed state, but an organic polymer compound is preferable. When the non-conductor layer 142 contains an organic polymer compound, the non-conductor layer 142 can be flexibly formed, and therefore the thermoelectric element 1 having a shape in accordance with the application such as curving or bending can be formed.

As the organic polymer compound, polyimide, polyamide, polyester, polycarbonate, poly (meth) acrylate, a radical polymerization-type photocurable or thermosetting resin, a photocationic polymerization-type photocurable or thermosetting resin, an epoxy resin, a copolymer containing an acrylonitrile component, polyvinyl phenol, polyvinyl alcohol, polystyrene, a novolak resin, polyvinylidene fluoride, or the like can be used.

For example, an inorganic substance may be used as the non-conductor layer 142. Examples of the inorganic substance include porous inorganic substances such as, for example, zeolite and diatomaceous earth, and caged molecules.

### First substrate 15 and second substrate 16

For example, as illustrated in FIG. 5(a), the first substrate 15 and the second substrate 16 are provided apart from each other in the first direction Z with the electrodes 11 and 12 and the intermediate portion 14 interposed therebetween. The first substrate 15 is in contact with, for example, the first electrode 11 and is separated from the second electrode 12. The first substrate 15 fixes the first electrode 11. The second substrate 16 is in contact with the second electrode 12 and is separated from the first electrode 11. The second substrate 16 fixes the second electrode 12.

The thickness along the first direction Z of each of the substrates 15 and 16 is, for example, equal to or greater than 10 µm and equal to or less than 2 mm. The thickness of each of the substrates 15 and 16 can be arbitrarily set. The shape of each of the substrates 15 and 16 may be a quadrangle of, for example, a square or a rectangle, as well as a disk shape or the like, and can be arbitrarily set depending on the application.

As each of the substrates 15 and 16, a plate-like member having an insulating property, for example, can be used, and a known member such as, for example, silicon, quartz, and Pyrex (registered trademark) can be used. For each of the substrates 15 and 16, for example, a film-shaped member may be used, and a known film-shaped member such as, for example, polyethylene terephthalate (PET), polycarbonate (PC), or polyimide may be used.

As each of the substrates 15 and 16, a member having conductivity, for example, can be used, and examples thereof include, for example, iron, aluminum, copper, or an alloy of aluminum and copper. As each of the substrates 15 and 16, a member such as a conductive polymer may be used in addition to a semiconductor having conductivity such as, for example, Si or GaN. When a member having conductivity is used for each of the substrates 15 and 16, wiring for connecting to each of the electrodes 11 and 12 becomes unnecessary.

For example, when the first substrate 15 is a semiconductor, it may include a degenerate portion in contact with the first electrode 11. In this case, the contact resistance between the first electrode 11 and the first substrate 15 can be reduced as compared with the case of not including a degenerate portion. The first substrate 15 may have a degenerate portion on a surface different from the surface in contact with the first electrode 11. In this case, it is possible to reduce the contact resistance with the wiring (e.g., first wiring 101) electrically connected to the first substrate 15.

For example, when a plurality of the thermoelectric elements 1 illustrated in FIG. 5(a) are layered, a semiconductor may be used as the first substrate 15 and the second substrate 16. In this case, it is possible to reduce the contact resistance by providing the degenerate portion on the contact surface of each of the substrates 15 and 16 in contact with each other as the thermoelectric elements 1 are layered.

The degenerate portion described above is produced by, for example, ion-implanting an n-type dopant into a semiconductor at a high concentration, or coating a semiconductor with a material such as glass containing an n-type dopant, followed by performing heat treatment.

Examples of the impurity doped in the first substrate 15 of the semiconductor include known impurities such as P, As, and Sb in the case of the n-type, and B, Ba, and Al in the case of the p-type. When the concentration of the impurity in the degenerate portion is, for example, 1 × 10¹⁹ ions/cm³, electrons can be efficiently emitted.

For example, when the first substrate 15 is a semiconductor, the specific resistance value of the first substrate 15 may be, for example, equal to or greater than 1 × 10⁻⁶ Ω·cm and equal to or less than 1 × 10⁶ Ω·cm. When the specific resistance value of the first substrate 15 falls below 1 × 10⁻⁶ Ω·cm, it is difficult to select a material. When the specific resistance value of the first substrate 15 is greater than 1 × 10⁶ Ω·cm, there is a concern that a current loss increases.

Although the case where the first substrate 15 is a semiconductor has been described above, the second substrate 16 may be a semiconductor. In this case, since the description is similar to the above, the description will be omitted.

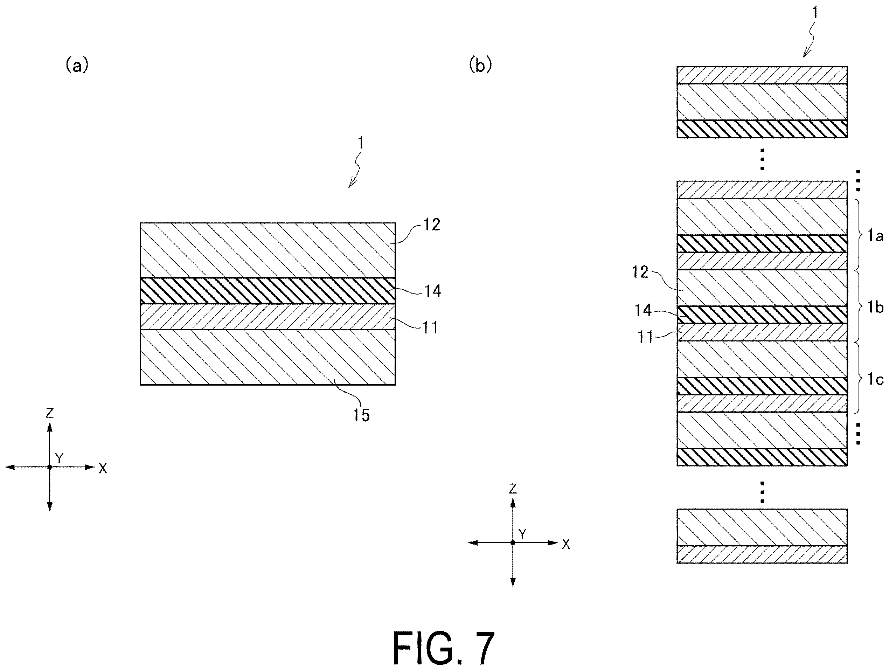

The thermoelectric element 1 may include only the first substrate 15 as illustrated in FIG. 7(a), or may include only the second substrate 16. As illustrated in FIG. 7(b), for example, the thermoelectric element 1 may have a layered structure (e.g., 1a, 1b, 1c, and the like) in which a plurality of the first electrodes 11, the intermediate portions 14, and the second electrodes 12 are layered in this order without including the substrates 15 and 16, or may have a layered structure including at least any of the substrates 15 and 16, for example.

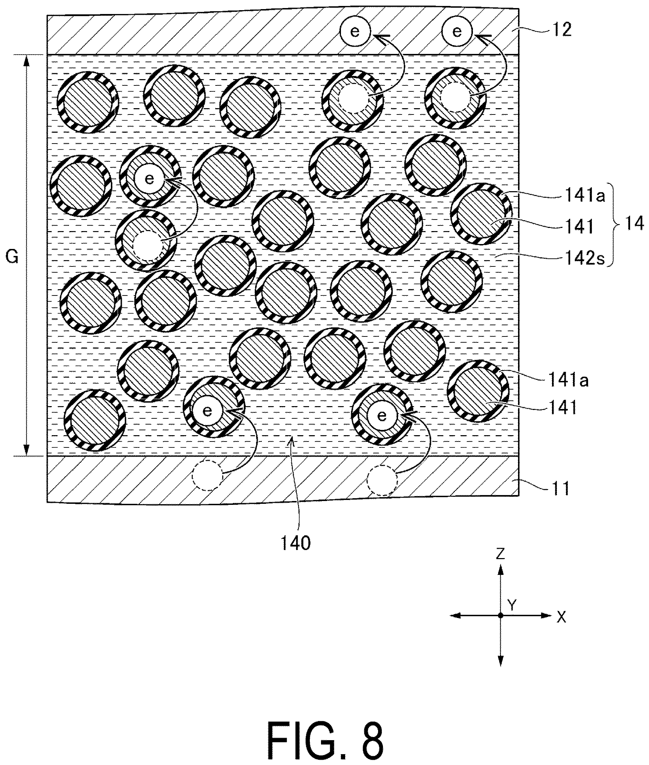

For example, as illustrated in FIG. 8, the intermediate portion 14 may contain a solvent 142s in place of the non-conductor layer 142. In this case, the fine particles 141 are dispersed in the solvent 142s. Each of the electrodes 11 and 12 is supported by a support portion not illustrated. As the solvent 142s, for example, a known liquid such as water or toluene is used. Also in this case, by containing the first fine particles 141f and the second fine particles 141s described above, it becomes possible to suppress a decrease in power generation amount.

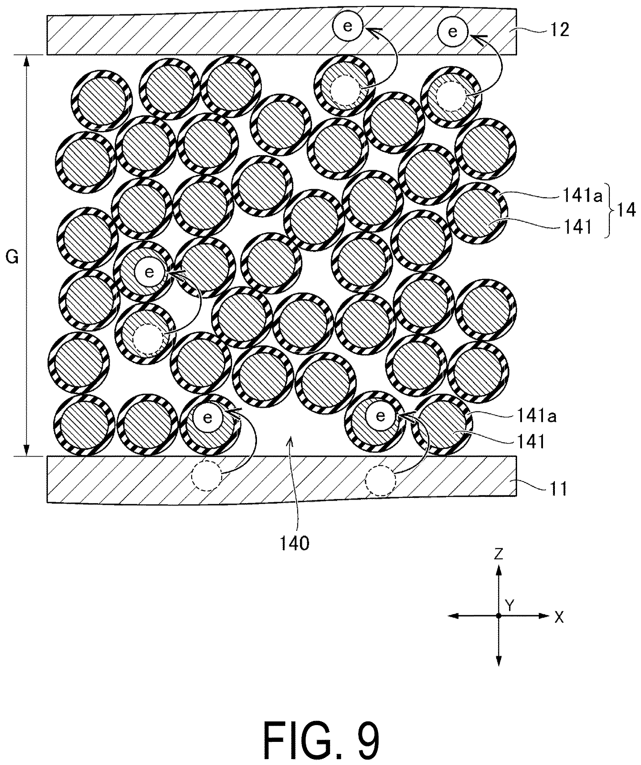

The intermediate portion 14 needs not include the non-conductor layer 142, for example, as illustrated in FIG. 9. In this case, the gap G is filled with the fine particles 141. Each of the electrodes 11 and 12 is supported by a support portion not illustrated. Also in this case, by containing the first fine particles 141f and the second fine particles 141s described above, it becomes possible to suppress a decrease in power generation amount.

### Operation example of thermoelectric element 1

For example, when thermal energy is imparted to the thermoelectric element 1, a current is generated between the first electrode 11 and the second electrode 12, and the thermal energy is converted into electric energy. The current amount generated between the first electrode 11 and the second electrode 12 depends not only on the thermal energy but also on the difference between the work function of the second electrode 12 and the work function of the first electrode 11.

The current amount to be generated can be increased, for example, by increasing the work function difference between the first electrode 11 and the second electrode 12 and decreasing the gap G. For example, the amount of electric energy generated by the thermoelectric element 1 can be increased by considering at least any one of increasing the work function difference and decreasing the gap G. By providing the fine particles 141 between the electrodes 11 and 12, it is possible to increase the amount of electrons moving between the electrodes 11 and 12, and it becomes possible to lead to an increase in the current amount.

The "work function" indicates minimum energy required for extracting, into a vacuum, electrons in a solid. The work function can be measured using, for example, ultraviolet photoelectron spectroscopy (UPS), X-ray photoelectron spectroscopy (XPS), or Auger electron spectroscopy (AES). As the "work function", not only an actual measurement value targeting each configuration of the thermoelectric element 1 but also a known value measured for a material, for example, may be used.

According to the present embodiment, the thermoelectric element 1 is in contact with the heat medium 3 having a temperature equal to or higher than a temperature of outside air. Therefore, it is possible to suppress fluctuation over time of heat transferred to the thermoelectric element 1. This makes it possible to achieve stable power generation.

According to the present embodiment, the intermediate portion 14 includes the non-conductor layer 142 containing the fine particles 141. That is, the non-conductor layer 142 suppresses movement of the fine particles 141 between the electrodes. Therefore, it is possible to suppress the fine particles 141 from being unevenly distributed over time on one electrode side and the movement amount of electrons from decreasing. This makes it possible to achieve stabilization of the power generation amount.

According to the present embodiment, the non-conductor layer 142 supports the pair of electrodes 11 and 12. Therefore, as compared with a case of using a solvent or the like in place of the non-conductor layer 142, it is not necessary to provide a support portion or the like for maintaining the distance (gap G) between the electrodes, and can eliminate variation in the gap G due to the formation accuracy of the support portion. This makes it possible to suppress variation in power generation amount.

According to the present embodiment, the pair of electrodes 11 and 12 are sandwiched between the heat medium 3. Therefore, it is possible to further suppress fluctuation over time of heat transferred to the thermoelectric element 1. This makes it possible to achieve more stable power generation.

According to the present embodiment, the thermoelectric element 1 is provided in contact with the housing portion 21. Therefore, thermal energy generated from the secondary battery 2 can be converted into electric energy via the thermoelectric element 1. This makes it possible to achieve an increase in the power generation amount. Exhaust heat generated with use of the secondary battery 2 can be effectively used.

According to the present embodiment, the thermoelectric element 1 is provided in contact between the housing portion 21 and the heat storage portion. Therefore, it is possible to easily suppress the temporal change of the thermal energy amount supplied to the thermoelectric element 1. This makes it possible to achieve further stabilization of the power generation amount.

According to the present embodiment, the thermoelectric element 1 is in contact with the inner wall of the container 31. Therefore, thermal energy transferred to the container 31 can be converted into electric energy via the thermoelectric element 1. This makes it possible to achieve an increase in the power generation amount.

According to the present embodiment, the thermoelectric element 1 is in contact with the circuit board 4. Therefore, thermal energy generated on the circuit board 4 by arithmetic processing or the like can be converted into electric energy via the thermoelectric element 1. This makes it possible to achieve an increase in the power generation amount. Exhaust heat generated with arithmetic processing or the like can be effectively used.

According to the present embodiment, the thermoelectric element 1 and the secondary battery 2 are provided on an identical main surface of the circuit board 4. Therefore, it is possible to suppress thermal energy generated from the secondary battery 2 from being retained in the circuit board 4. This makes it possible to suppress quality deterioration such as deterioration of the circuit board 4 and calculation speed decrease.

According to the present embodiment, the thermoelectric element 1 is provided in contact between the circuit board 4 and the housing portion 21. Therefore, it is possible to suppress thermal energy generated from the secondary battery 2 from being directly transferred to the circuit board 4. This makes it possible to suppress quality deterioration such as deterioration of the circuit board 4 and calculation speed decrease.

According to the present embodiment, the thermoelectric element 1 is in contact with the drive portion. Therefore, thermal energy generated from the drive portion can be converted into electric energy via the thermoelectric element 1. This makes it possible to achieve an increase in the power generation amount. Exhaust heat generated from the drive portion can be effectively used.

According to the present embodiment, for example, the thermoelectric element 1 may be electrically connected to the secondary battery 2 via a booster circuit. In this case, when the secondary battery 2 is charged using the power generation of the thermoelectric element 1, it becomes possible to achieve shortening of the charging time.

According to the present embodiment, for example, the control unit 6 may control a charging condition of the secondary battery 2 charged via the thermoelectric element 1. In this case, the charging condition can be controlled based on the charging and discharging state of the secondary battery 2 and the power generation state of the thermoelectric element 1. This makes it possible to achieve suppression of early deterioration of the secondary battery 2.

According to the present embodiment, for example, the secondary battery 2 may be electrically connected to the drive portion, and the thermoelectric element 1 may be electrically separated from the drive portion. In this case, it is possible to use the power generation system without changing the connection relationship between the known secondary battery 2 and the drive portion. This makes it possible to improve convenience of the power generation system.

According to the present embodiment, for example, the control unit 6 may control a condition of electric power supplied from the secondary battery 2 to the drive portion. In this case, the electric power supplied from the secondary battery 2 can be controlled in accordance with variation in power generation of the thermoelectric element 1. This makes it possible to achieve supply of stable electric power.

According to the present embodiment, for example, the control unit 6 may control, as a charging condition, the electrical connection relationship between the secondary battery 2 and the plurality of elements. In this case, it is possible to avoid a charging condition that imparts a load to the secondary battery 2, and to perform charging suitable for the state of the secondary battery 2. This makes it possible to further suppress early deterioration of the secondary battery 2.

According to the present embodiment, for example, the fine particles 141 may include the first fine particles 141f and the second fine particles 141s having the median diameter D50s smaller than that of the first fine particles 141f. In this case, it is possible to increase the possibility that the second fine particles 141s enter between the particles of the first fine particles 141f, and it is possible to suppress the fluctuation in the dispersion state of the fine particles 141. This makes it possible to suppress a decrease in power generation amount.

According to the present embodiment, for example, the particle number concentration of the first fine particles 141f may be lower than the particle number concentration of the second fine particles 141s. That is, it is possible to increase the filling degree of the fine particles 141 between the electrodes 11 and 12. Therefore, it is possible to further suppress the fluctuation in the dispersion state of the fine particles 141. This makes it possible to achieve further suppression of decrease in the power generation amount.

According to the present embodiment, for example, the non-conductor layer 142 may contain an organic polymer compound. In this case, the non-conductor layer 142 can be flexibly formed. This makes it possible to form the thermoelectric element 1 having a shape in accordance with the application.

According to the present embodiment, for example, the intermediate portion 14 may be provided on the first electrode 11 and include the solid non-conductor layer 142 and the fine particles 141 fixed in a state of being dispersed in the non-conductor layer 142. That is, the non-conductor layer 142 suppresses movement of the fine particles 141 between the electrodes (the first electrode 11 and the second electrode 12). In this case, it is possible to suppress the fine particles 141 from being unevenly distributed over time on one electrode side and the movement amount of electrons from decreasing. This makes it possible to achieve stabilization of the power generation amount.

According to the present embodiment, for example, the intermediate portion 14 may be provided on the first electrode 11 and may include the solid non-conductor layer 142. The second electrode 12 may be provided on the non-conductor layer 142 and may have a work function different from that of the first electrode 11. In this case, as compared with a case where a solvent or the like is used in place of the non-conductor layer 142, it is not necessary to provide a support portion or the like for maintaining the distance (gap G) between the electrodes, making it possible to eliminate variation in the gap G due to the formation accuracy of the support portion or the like. This makes it possible to suppress variation in power generation amount.

Although some embodiments of the present invention have been described, these embodiments have been presented as examples, and are not intended to limit the scope of the invention. These novel embodiments can be implemented in various other forms, and various omissions, substitutions, and changes can be made without departing from the gist of the invention. These embodiments and modifications thereof are included in the scope and gist of the invention, and are included in the inventions described in the claims and the equivalent scope thereof.

### Reference Signs List

1: Thermoelectric element
11: First electrode
12: Second electrode
14: Intermediate portion
15: First substrate
16: Second substrate
17: Sealing material
2: Secondary battery
3: Heat medium
3f: First heat medium
3s: Second heat medium
4: Circuit board
5: Charging circuit
51: Rectifier circuit
52: Smoothing circuit
53: Voltage limiter
6: Control unit
100: Power generation function-equipped secondary battery
140: Space
141: Fine particles
141a: Coating
142: Non-conductor layer
142s: Solvent
G: Gap
R: Load
Z: First direction
X: Second direction
Y: Third direction

## Claims

1. A power generation function-equipped secondary battery using a thermoelectric element, the power generation function-equipped secondary battery comprising:
the thermoelectric element, the thermoelectric element being in contact with a heat medium that has a temperature equal to or higher than a temperature of outside air and not requiring a temperature difference between electrodes; and
a secondary battery electrically connected to the thermoelectric element, wherein
the thermoelectric element includes a pair of electrodes having work functions different from each other.

2. The power generation function-equipped secondary battery according to claim 1, wherein
the thermoelectric element includes an intermediate portion provided between the pair of electrodes and including a non-conductor layer containing fine particles, and
the non-conductor layer supports the pair of electrodes.

3. The power generation function-equipped secondary battery according to claim 1 or 2, wherein
the pair of electrodes are sandwiched between the heat medium.

4. The power generation function-equipped secondary battery according to any one of claims 1 to 3, wherein
the heat medium includes a housing portion of the secondary battery, and
the thermoelectric element is provided in contact with the housing portion.

5. The power generation function-equipped secondary battery according to claim 4, wherein
the heat medium includes a heat storage portion that stores thermal energy, and
the thermoelectric element is provided in contact between the housing portion and the heat storage portion.

6. The power generation function-equipped secondary battery according to any one of claims 1 to 4, wherein
the heat medium includes a container internally provided with the thermoelectric element and the secondary battery, and
the thermoelectric element is in contact with an inner wall of the container.

7. The power generation function-equipped secondary battery according to any one of claims 1 to 3, wherein
the heat medium includes a circuit board, and
the thermoelectric element is in contact with the circuit board.

8. The power generation function-equipped secondary battery according to claim 7, wherein the thermoelectric element and the secondary battery are provided on an identical main surface of the circuit board.

9. The power generation function-equipped secondary battery according to claim 7, wherein
the heat medium includes a housing portion of the secondary battery, and
the thermoelectric element is provided in contact between the circuit board and the housing portion.

10. The power generation function-equipped secondary battery according to any one of claims 1 to 4, wherein
the heat medium includes a drive portion supplied with electric power from the secondary battery, and
the thermoelectric element is in contact with the drive portion.
